# EUROPEAN PATENT SPECIFICATION

(11) **EP 3 145 042 B1**
(45) Date of publication and mention of the grant of the patent: **17.03.2021**
(21) Application number: 15185436.1
(22) Date of filing: 16.09.2015
(51) Int. Cl.: H02H 7/06, H02P 9/00, H02H 3/16

(54) **A SHAFT GENERATOR ARRANGEMENT OF A SHIP**
WELLENGENERATORANORDNUNG EINES SCHIFFES
AGENCEMENT DE GÉNÉRATEUR À ARBRE D'UN NAVIRE

(43) Date of publication of application: 22.03.2017
(73) Proprietor: WE Tech Solutions Oy, 65200 Vaasa (FI)
(72) Inventor: STORBACKA, Mårten, 65200 Vaasa (FI); ASIKAINEN, Jesse, 65200 Vaasa (FI); WESTERLUND, Kim, 65200 Vaasa (FI)
(74) Representative: Berggren Oy, Helsinki & Oulu

(56) References cited:
- WO-A1-2012/143245
- WO-A1-2013/071937
- US-A- 5 023 537

## Description

### Field of technology

The present invention relates to a shaft generator arrangement of a ship. More particularly the invention relates to a ship's main shaft generator arrangement having a protection arrangement.

### Prior art

A ship has a main engine that is arranged to rotate a propeller of a ship. The engine is for example a diesel or gas engine, and it is often called as main engine as well. A shaft connects the engine to the propeller and it is called as main shaft. In order to produce electric power for loads on the ship, the ship may have a separate engine (or engines) that is connected with a generator (or generators). Another solution is that a generator is in connection with the main shaft which means that the main engine rotates the propeller and also produces electric power through the generator. The generator around the main shaft is called as shaft generator. The generator of the shaft generator is connected to the grid of the ship through a generator breaker.

The shaft generator is normally a separately exited generator which means that direct current (DC) voltage is supplied to the windings of the rotor. Shaft generators have been used for decades, and they have proved to be efficient and reliable in marine environment.

If malfunction occurs in the generator, the generator breaker is opened for disconnecting the generator from the grid. It is also possible to disconnect the DC supply to the windings of the rotor in case of the separated exited generator in order to stop inducing voltage in the windings of the stator. In case of the permanent magnet generator, the engine is shut down to stop inducing voltage in the stator windings. If the generator is a shaft generator, shutting down main engine is not always possible due to e.g. navigational hazards.

WO 2013071937 which forms the preamble of claim 1, discloses a protection arrangement of a permanent magnet generator used in a power plant like in a wind power plant. This document shows a star point measurement in an generator. The measurement is utilized by a protection relay that commands a circuit breaker. WO2012143245 discloses a solution wherein an ACDC power converter is protected by an additional short-circuiting circuit.

### Short description of invention

The aim of the invention is to provide a solution wherein the main shaft permanent magnet generator has a protection arrangement that allows the main engine to run even if the generator has a fault situation. The aim is achieved in a way described in the independent claim.

A shaft generator arrangement of a ship according to the invention comprises a permanent magnet generator to be in connection with a main shaft of the ship, and a frequency transformer arranged to transform voltage of the generator. The arrangement has also a generator breaker between the generator and the frequency transformer through which the generator is connectable to the frequency transformer. The windings of the permanent magnet generator are connected to a star point, and which arrangement comprises a star point breaker located close to the generator between the windings and the star point. The connection between the generator and the main shaft is to be arranged by mounting the generator around the main shaft or via gearing.

The arrangement further comprises a first current measurement arranged to measure currents between the generator and the frequency transformer, and a second current measurement arranged to measure currents between the windings and the star point, and a protection relay that is connectable to the first and the second current measurements and to the star point breaker and the generator breaker. The protection relay is arranged to open the star point breaker if 2- or 3 - phase short circuit between the phases of the generator is detected as response to the second measurement, and to open the generator breaker if double ground fault is detected as response to said first and second measurements.

The protection relay is arranged to open the star point breaker due the malfunction of the generator breaker, and the protection relay has an overcurrent protection function to detect overcurrent in case of the 2- or 3 -phase short circuit, and a differential current protection function to detect differential current in case of the double ground fault.

### List of figures

In the following, the invention is described in more detail by reference to the enclosed drawings, where
- Figure 1: illustrates an embodiment of the inventive arrangement,
- Figure 2: illustrates a frequency transformer of the inventive arrangement in more detail, and
- Figure 3: illustrates an embodiment of the inventive arrangement with a transmission gear.

### Description of the invention

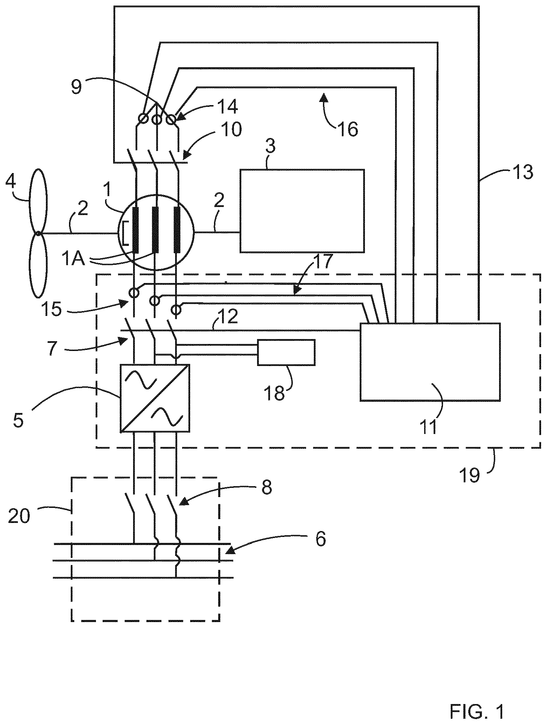

Figure 1 illustrates an example of an arrangement according to the invention. The shaft generator arrangement of a ship comprises a permanent magnet generator 1 that can be arranged around a main shaft 2 of the ship thus being in connection with the main shaft. The ship's main engine 3 provides power to the main shaft in order to rotate a propeller 4 of the ship. The generator around the main shaft transforms a part of the power into an electric form, which can be used in loads connected to electrical grid 6 of the ship. The permanent magnet generator 1 provides at least 0.5 MVA. The arrangement has a frequency transformer 5 arranged to transform voltage of the generator 1, and a generator breaker 7 between the generator 1 and the frequency transformer 5 through which breaker 7 the generator is connectable to the frequency transformer. The transformation of voltage means in this context that amplitude, frequency and/or phase of the voltage is changed.

The windings 1A of the permanent magnet generator (more precisely the windings of the stator) are connected to a star point 9. Further, the generator 1 comprises a star point breaker 10 between the windings and the star point.

The arrangement further comprises a first current measurement 15 arranged to measure currents between the generator 1 and the frequency transformer 5, and a second current measurement 14 arranged to measure currents on the windings 1A near the star point 9, and a protection relay 11 that is connectable to the first 15 and the second 14 current measurement and to the star point breaker 10 and the generator breaker 7 through corresponding connections 17, 16, 13, 12. The connections with the first and second measurements 17, 16 provide measurement data to the protection relay, which drives the breakers 7, 10 to open if needed as response/s to said measurements.

The protection relay 11 is arranged to open the star point breaker 10 if 2- or 3 - phase short circuit between the phases of the generator is detected as response to the first 15 or second 14 measurement and to open the generator breaker 7 if double ground fault is detected as response to said first 15 and second 14 measurements. Since each winding of the generator is phase specific, 2- or 3 -phase short circuit can be a short circuit between the windings or between the lines of the phases. The protection relay 11 is also arranged to open the star point breaker 10 due the malfunction of the generator breaker 7.

The protection relay has an overcurrent protection function to detect overcurrent in case of the 2- or 3 -phase short circuit, and a differential current protection function to detect differential current in case of the double ground fault. The double ground fault occurs when there exist two simultaneous ground faults. One ground fault can be in the generator and the other ground fault in the grid of the ship. In this case the fault current flows through the ground (the ship's hull) and the frequency converter. Table 1 below shows some characteristics of the protection relay.

**Table 1. Protection relays characteristics**

| **Function** | **Characteristics** |
|---|---|
| Overcurrent protection | Pick-up current setting: 0,1 ... 40 x In (RMS or peak-to-peak) |
| | Pick-up inaccuracy: ±0,5% *I* or ±15mA; |
| | Instant operation time: <50ms |
| Current differential protection | Pick-up current setting: 0.01 ... 100% ID *iff* |
| | Pick-up inaccuracy: ±1,5% or ±30mA |
| | Instant operation time: <40ms |

The arrangement may further comprise a ground fault detection device 18 to detect a single ground fault and providing a ground fault message for monitoring the arrangement. In this embodiment the protection relay 11 can also be arranged to open the star point breaker in case of the frequency transformer is stopped and the ground fault message is provided. Since the electric systems are insulated in seagoing vessels as IT (Insulated Terra) systems, the ground fault detection device 18 detects faults in the insulation decreasing the resistance of the insulation material.

The arrangement further comprises a star point breaker cabinet having the star point, the star point breaker and the second current measurement at a vicinity of the permanent magnet generator. It can be noted that in previous solutions breakers are situated relatively far away from the generator.

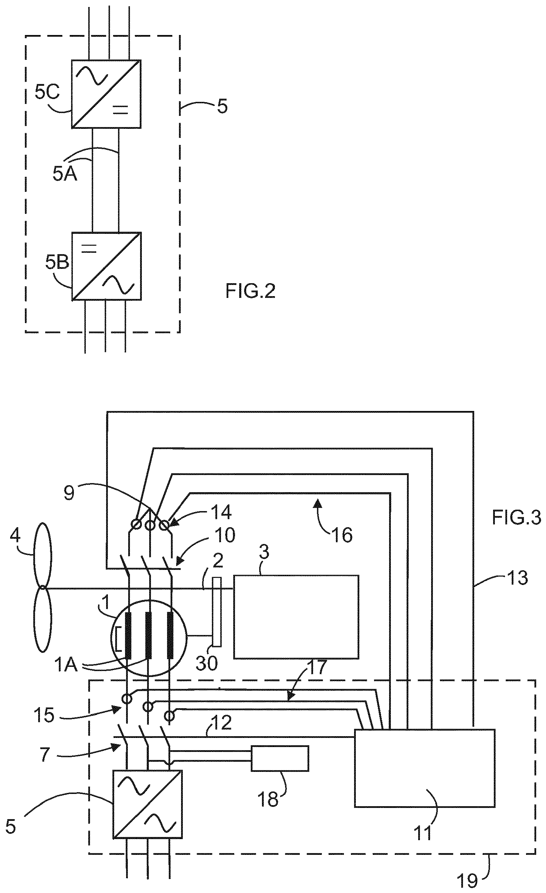

The frequency transformer 5 may comprise a direct current bridge 5A and two inverters 5A, 5B, one being connected for the generator 1 and the other for the grid 6. This kind of structure illustrated in figure 2 provides good driving possibilities. It is also possible to supply power from the grid to the generator, which in this case runs as electric machine. In this way the propeller 4 of ship can be rotated even if the main engine 3 is not running, for example due to a fault situation.

The arrangement can comprise a grid breaker 8 between the frequency transformer and the grid of the ship. It is convenient to place in a main switch board 20.

So, the invention makes it possible to utilize the permanent magnet generator with the main shaft of the ship in such a way that the main engine runs to rotate the propeller even if the generator has a fault. In any fault situations the star point breaker can be opened. The inventive arrangement is at least as reliable as prior art solutions like the separately exited generators. Therefore the inventive permanent magnet shaft generator arrangement provides a new and reliable solution, also for more powerful arrangements, like at least 1.5 MVA, and as marine standards require.

In order that the inventive system runs properly several items have be considered. The corresponding prior art solutions rely on the switching voltage off (the separate excitation) but the invention has a new approach of switching current off (star point breaker). The protection relay arrangement have to control both generator breaker and star point breaker in such a way that switch actions of the breakers do not hinder each other or cause malfunctions. In addition, the arrangement having said breakers and measurements and the protection relay has to work at variable frequency level (possibly also in low frequency level). For example in case of a usual embodiment the permanent magnet generator runs in a range of 5 - 30 Hz AC in its stator windings. This is due to the rotation speed of the main shaft that is in many solutions about 50 - 100 rpm at nominal speed. So, the components of the arrangement should be suitable for the said low frequency range. If gearing is used, the frequency range in the stator windings can be, for example 30 - 75 Hz. Variable shaft generator frequency levels (ranges 5 - 30 Hz and 30 - 75 Hz) has be to taken into account in order to provide power to the vessels electrical grid having e.g. 50 or 60 Hz frequency or DC-distribution. Further the permanent magnet generator can be arranged to provide at least 1.5 MVA, which means that the arrangement should fulfil reliability and safety requirements being determined by the marine standards already mentioned above.

It may be possible that a ship has two main shafts 2. In this case according to the invention the arrangement comprises another permanent magnet generator being connectable with another main shaft of the ship, and another generator breaker between the other generator and the frequency transformer through which the other generator is connectable to the frequency transformer. Windings of the other permanent magnet generator are connected to another star point, and the arrangement comprises another star point breaker between the windings of the other permanent magnet generator and the other star point. The arrangement further comprises another first current measurement arranged to measure currents between the other generator and the frequency transformer, and another second current measurement arranged to measure currents between the windings of the other permanent magnet generator and the other star point. The other elements correspond with the generator, the breaker, the star point and the first and second measurement described above and illustrated in figure 1. So the same reference numbers can also be used to refer to the other elements.

The protection relay is connectable to the other first and the other second current measurement and to the other star point breaker and the other generator breaker. The protection relay is correspondingly arranged to open the other star point breaker if 2- or 3 -phase short circuit between the phases of the other generator is detected as response to the other first or other second measurement, and open the other generator breaker if double ground fault is detected as response to said other first and other second measurements. Instead of the protection relay there can be another protection relay that is arranged to do these tasks and has said connections.

The figures of this presentation are schematic figures, so in real solutions there can be other devises as well, for example voltage limiting units and filters within the frequency transformer. Since the power system are usually with three phases said breakers and current measurements has connections with each phase. Although the protection relay 11 is described as one device in figure 1, it may also be distributed into several locations, like near the breakers, but still working together as one protection relay described above. The protection relay 11 can be situated with the same cabinet 19 with the frequency transformer as well as the ground fault detection device 18, the generator breaker 7 and also the first current measurement. The star point breaker is situated within the generator assembly, or on the generator or in a cabinet at vicinity of the generator.

The generator also works with in high torque at low rotation speed. However, if desired, the inventive arrangement can be constructed with a transmission gear 30 as well as described in figure 3. In this case the generator can also be connected via the transmission gear. In addition, it can be noted that in case of 2- or 3- phase short circuit, the short circuit current can be stopped even if the frequency transformer does not run and the generator breaker is open. This is not possible in prior art permanent magnet solutions.

It is evident from the above that the invention is not limited to the embodiments described in this text but can be implemented in many other different embodiments within the scope of the accompanying claims.

## Claims

1. A shaft generator arrangement for a ship, the arrangement comprising a permanent magnet generator (1) being connectable with a main shaft (2) of the ship, a frequency transformer (5) arranged to transform voltage of the generator (1), and a generator breaker (7) between the generator (1) and the frequency transformer (5) through which the generator (1) is connected to the frequency transformer (5), wherein windings (1A) of the permanent magnet generator (1) are connected to a star point (9), and which arrangement comprises a star point breaker (10) between the windings and the star point,
the arrangement further comprising a first current measurement (15) arranged to measure currents between the generator (1) and the frequency transformer (5), the shaft generator arrangement is **characterised by** comprising f
a second current measurement (14) arranged to measure currents between the windings (1A) and the star point (9), and a protection relay (11) that is connected to the first (15) and the second (14) current measurement and to the star point breaker (10) and the generator breaker (7), which protection relay (11) is arranged to open the star point breaker (10) if 2- or 3 -phase short circuit between the phases of the generator is detected as response to the first (15) or second (14) measurement, and open the generator breaker (7) if double ground fault is detected as response to said first (15) and second (14) measurements, and
the protection relay (11) being arranged to open the star point breaker (10) due the malfunction of the generator breaker (7), and
the protection relay (11) has an overcurrent protection function to detect overcurrent in case of the 2- or 3 -phase short circuit, and a differential current protection function to detect differential current in case of the double ground fault.

2. A shaft generator arrangement for a ship according to Claim 1, wherein the arrangement further comprises an ground fault detection device (18) to detect a single ground fault and providing a ground fault message for monitoring the arrangement.

3. A shaft generator arrangement for a ship according to any of the Claims from 1 to 2, wherein the arrangement further comprises a star point breaker cabinet having the star point (9), the star point breaker (10) and the second current measurement (14) at a vicinity of the permanent magnet generator (1).

4. A shaft generator arrangement for a ship according to Claim 3, wherein the frequency transformer (5) comprises a direct current bridge (5A) and two inverters (5B, 5C).

5. A shaft generator arrangement for a ship according to any of the Claims from 1 to 4, wherein the permanent magnet generator (1) runs at variable speed or fixed speed.

6. A shaft generator arrangement for a ship according to any of the Claims from 1 to 5, Wherein the permanent magnet generator (1) provides at least 0.5 MVA.

7. A shaft generator arrangement for a ship according to any of the Claims from 1 to 6, wherein the permanent magnet generator (1) is around the main shaft (2).

8. A shaft generator arrangement for a ship according to any of the Claims from 1 to 6, wherein the arrangement comprises a transmission gear (30) of the main shaft (2) and the permanent magnet generator (1) is in connection with the main shaft (2) through the transmission gear (30).

9. A shaft generator arrangement for a ship according to any of the Claims from 1 to 8, wherein the arrangement further comprises another permanent magnet generator (1) being connected with another main shaft (2) of the ship, and another generator breaker (7) between the other generator and the frequency transformer (5) through which the other generator (1) is connectedto the frequency transformer, and windings (1A) of the other permanent magnet generator are connected to another star point (9), and which arrangement comprises another star point breaker (10) between the windings of the other permanent magnet generator and the other star point, the arrangement further comprising another first current measurement (15) arranged to measure currents between the other generator (1) and the frequency transformer (5), and anothersecond current measurement (14) arranged to measure currents between the windings (1A) of the other permanent magnet generator (1) and the other star point 9).

10. A shaft generator arrangement for a ship according to Claim 9, wherein the protection relay (11) is connected to the other first (15) and the other second (14) current measurement and to the other star point breaker (10) and the other generator breaker (7), which protection relay is arranged to open the other star point breaker if 2- or 3 -phase short circuit between the phases of the other generator is detected as response to the other first or other second measurement, and open the other generator breaker if double ground fault is detected as response to said other first and other second measurements.

11. A shaft generator arrangement for a ship according to any of the Claims from 1 to 8, wherein the arrangement further comprises another protection relay (11) is connected to the other first (15) and the other second (14) current measurement and to the other star point breaker (10) and the other generator breaker (7), which protection relay is arranged to open the other star point breaker if 2- or 3 -phase short circuit between the phases of the other generator is detected as response to the other first or other second measurement, and open the other generator breaker if double ground fault is detected as response to said other first and other second measurements.

12. A shaft generator arrangement for a ship according to any of the Claims from 1 to 11, wherein the arrangement comprises a grid breaker (8) between the frequency transformer (5) and the grid (6) of the ship.

## Patentansprüche

1. Wellengeneratoranordnung für ein Schiff, wobei die Anordnung einen Permanentmagnetgenerator (1), der mit einer Hauptwelle (2) des Schiffes verbindbar ist, einen Frequenztransformator (5), der angeordnet ist, um die Spannung des Generators (1) umzuwandeln, und einen Generatorunterbrecher (7) zwischen dem Generator (1) und dem Frequenztransformator (5), über den der Generator (1) mit dem Frequenztransformator (5) verbunden ist, umfasst; wobei die Wicklungen (1A) des Permanentmagnetgenerators (1) mit einem Sternpunkt (9) verbunden sind, und die Anordnung einen Sternpunktunterbrecher (10) zwischen den Wicklungen und dem Sternpunkt umfasst,
wobei die Anordnung ferner eine erste Strommessung (15) umfasst, die angeordnet ist, um Ströme zwischen dem Generator (1) und dem Frequenztransformator (5) zu messen, die Wellengeneratoranordnung **gekennzeichnet durch** eine zweite Strommessung (14), die angeordnet ist, um Ströme zwischen den Wicklungen (1A) und dem Sternpunkt (9) zu messen, und ein Schutzrelais (11), das mit der ersten (15) und der zweiten (14) Strommessung und mit dem Sternpunktunterbrecher (10) und dem Generatorunterbrecher (7) verbunden ist, wobei das Schutzrelais (11) angeordnet ist, um den Sternpunktunterbrecher (10) zu öffnen, wenn ein 2- oder 3-Phasen-Kurzschluss zwischen den Phasen des Generators als Reaktion auf die erste (15) oder zweite (14) Messung erkannt wird, und um den Generatorunterbrecher (7) zu öffnen, wenn ein doppelter Erdschluss als Reaktion auf die erste (15) und zweite (14) Messung erkannt wird, und
das Schutzrelais (11) angeordnet ist, um den Sternpunktunterbrecher (10) aufgrund einer Fehlfunktion des Generatorunterbrechers (7) zu öffnen, und
das Schutzrelais (11) über eine Überstromschutzfunktion zur Erkennung eines Überstroms bei einem 2- oder 3-Phasen-Kurzschluss und eine Differenzstromschutzfunktion zur Erkennung eines Differenzstroms bei einem doppelten Erdschluss verfügt.

2. Wellengeneratoranordnung für ein Schiff nach Anspruch 1, wobei die Anordnung ferner eine Erdschlusserfassungsvorrichtung (18) zum Erfassen eines einzelnen Erdschlusses und Bereitstellen einer Erdschlussnachricht zum Überwachen der Anordnung umfasst.

3. Wellengeneratoranordnung für ein Schiff nach einem der Ansprüche 1 bis 2, wobei die Anordnung ferner einen Sternpunktunterbrecherschrank mit dem Sternpunkt (9), dem Sternpunktunterbrecher (10) und der zweiten Strommessung (14) in der Nähe des Permanentmagnetgenerators (1) umfasst.

4. Wellengeneratoranordnung für ein Schiff nach Anspruch 3, wobei der Frequenztransformator (5) eine Gleichstrombrücke (5A) und zwei Wechselrichter (5B, 5C) umfasst.

5. Wellengeneratoranordnung für ein Schiff nach einem der Ansprüche 1 bis 4, wobei der Permanentmagnetgenerator (1) mit variabler Geschwindigkeit oder fester Geschwindigkeit läuft.

6. Wellengeneratoranordnung für ein Schiff nach einem der Ansprüche 1 bis 5, wobei der Permanentmagnetgenerator (1) mindestens 0,5 MVA liefert.

7. Wellengeneratoranordnung für ein Schiff nach einem der Ansprüche 1 bis 6, wobei sich der Permanentmagnetgenerator (1) um die Hauptwelle (2) befindet.

8. Wellengeneratoranordnung für ein Schiff nach einem der Ansprüche 1 bis 6, wobei die Anordnung ein Getriebezahnrad (30) der Hauptwelle (2) umfasst, und der Permanentmagnetgenerator (1) über das Getriebezahnrad (30) mit der Hauptwelle (2) verbunden ist.

9. Wellengeneratoranordnung für ein Schiff nach einem der Ansprüche 1 bis 8, wobei die Anordnung ferner einen anderen Permanentmagnetgenerator (1), der mit einer anderen Hauptwelle (2) des Schiffes verbunden ist, und einen weiteren Generatorunterbrecher (7) zwischen dem anderen Generator und dem Frequenztransformator (5), über den der andere Generator (1) mit dem Frequenztransformator verbunden ist, umfasst, und Wicklungen (1A) des anderen Permanentmagnetgenerators mit einem anderen Sternpunkt (9) verbunden sind, und wobei die Anordnung einen anderen Sternpunktunterbrecher (10) zwischen den Wicklungen des anderen Permanentmagnetgenerators und des anderen Sternpunkts umfasst, wobei die Anordnung ferner eine andere erste Strommessung (15), die angeordnet ist, um Ströme zwischen dem anderen Generator (1) und dem Frequenztransformator (5) zu messen, und eine weitere zweite Strommessung (14), die angeordnet ist, um Ströme zwischen den Wicklungen (1A) des anderen Permanentmagnetgenerators (1) und dem anderen Sternpunkt (9) zu messen, umfasst.

10. Wellengeneratoranordnung für ein Schiff nach Anspruch 9, wobei das Schutzrelais (11) mit der anderen ersten (15) und der anderen zweiten (14) Strommessung und mit dem anderen Sternpunktunterbrecher (10) und dem anderen Generatorunterbrecher (7) verbunden ist, wobei die Schutzrelais angeordnet ist, um den anderen Sternpunktunterbrecher zu öffnen, wenn ein 2- oder 3-phasiger Kurzschluss zwischen den Phasen des anderen Generators als Reaktion auf die andere erste oder andere zweite Messung erkannt wird und den anderen Generatorunterbrecher zu öffnen, wenn ein doppelter Erdschluss als Reaktion auf die anderen ersten und anderen zweiten Messungen erkannt wird.

11. Wellengeneratoranordnung für ein Schiff nach einem der Ansprüche 1 bis 8, wobei die Anordnung ferner ein anderes Schutzrelais (11) umfasst, das mit der anderen ersten (15) und der anderen zweiten (14) Strommessung und dem anderen Sternpunktunterbrecher (10) und dem anderen Generatorunterbrecher (7) verbunden ist, wobei das Schutzrelais angeordnet ist, um den anderen Sternpunktunterbrecher zu öffnen, wenn ein 2- oder 3-phasiger Kurzschluss zwischen den Phasen des anderen Generators als Reaktion auf die andere erste oder andere zweite Messung erkannt wird, und den anderen Generatorunterbrecher zu öffnen, wenn ein doppelter Erdschluss als Reaktion auf die anderen ersten und anderen zweiten Messungen erkannt wird.

12. Wellengeneratoranordnung für ein Schiff nach einem der Ansprüche 1 bis 11, wobei die Anordnung einen Gitterunterbrecher (8) zwischen dem Frequenztransformator (5) und dem Gitter (6) des Schiffes umfasst.

## Revendications

1. Agencement de générateur à arbre pour un navire, l'agencement comprenant un générateur à aimant permanent (1) pouvant être relié à un arbre principal (2) du navire, un transformateur de fréquence (5) agencé pour transformer la tension du générateur (1), et un disjoncteur de générateur (7) entre le générateur (1) et le transformateur de fréquence (5) à travers lequel le générateur (1) est relié au transformateur de fréquence (5), dans lequel des enroulements (1A) du générateur à aimant permanent (1) sont reliés à un point étoile (9), et lequel agencement comprend un disjoncteur de point étoile (10) entre les enroulements et le point étoile,
l'agencement comprenant en outre une première mesure de courant (15) agencée pour mesurer des courants entre le générateur (1) et le transformateur de fréquence (5), l'agencement de générateur à arbre est **caractérisé en ce qu'**il comprend une seconde mesure de courant (14) agencée pour mesurer des courants entre les enroulements (1A) et le point étoile (9), et un relais de protection (11) qui est relié à la première (15) et à la seconde (14) mesure de courant et au disjoncteur de point étoile (10) et au disjoncteur de générateur (7), lequel relais de protection (11) est agencé pour ouvrir le disjoncteur de point étoile (10) si un court-circuit à 2 ou 3 phases entre les phases du générateur est détecté en réponse à la première (15) ou à la seconde (14) mesure, et ouvrir le disjoncteur de générateur (7) si un double défaut à la terre est détecté en réponse auxdites première (15) et seconde (14) mesures, et
le relais de protection (11) étant agencé pour ouvrir le disjoncteur de point étoile (10) en raison du dysfonctionnement du disjoncteur de générateur (7), et
le relais de protection (11) a une fonction de protection contre les surintensités pour détecter des surintensités en cas de court-circuit à 2 ou 3 phases, et une fonction de protection de courant différentiel pour détecter le courant différentiel en cas de double défaut à la terre.

2. Agencement de générateur à arbre pour un navire selon la revendication 1, dans lequel l'agencement comprend en outre un dispositif de détection de défaut à la terre (18) pour détecter un seul défaut à la terre et fournissant un message de défaut à la terre pour surveiller l'agencement.

3. Agencement de générateur à arbre pour un navire selon l'une quelconque des revendications 1 et 2, dans lequel l'agencement comprend en outre une armoire de disjoncteur de point étoile ayant le point étoile (9), le disjoncteur de point étoile (10) et la seconde mesure de courant (14) à proximité du générateur à aimant permanent (1).

4. Agencement de générateur à arbre pour un navire selon la revendication 3, dans lequel le transformateur de fréquence (5) comprend un pont de courant continu (5A) et deux inverseurs (5B, 5C).

5. Agencement de générateur à arbre pour un navire selon l'une quelconque des revendications 1 à 4, dans lequel le générateur à aimant permanent (1) fonctionne à vitesse variable ou à vitesse fixe.

6. Agencement de générateur à arbre pour un navire selon l'une quelconque des revendications 1 à 5, dans lequel le générateur à aimant permanent (1) fournit au moins 0,5 MVA.

7. Agencement de générateur à arbre pour un navire selon l'une quelconque des revendications 1 à 6, dans lequel le générateur à aimant permanent (1) se trouve autour de l'arbre principal (2).

8. Agencement de générateur à arbre pour un navire selon l'une quelconque des revendications 1 à 6, dans lequel l'agencement comprend un engrenage de transmission (30) de l'arbre principal (2) et le générateur à aimant permanent (1) est en liaison avec l'arbre principal (2) à travers l'engrenage de transmission (30).

9. Agencement de générateur à arbre pour un navire selon l'une quelconque des revendications 1 à 8, dans lequel l'agencement comprend en outre un autre générateur à aimant permanent (1) étant relié à un autre arbre principal (2) du navire, et un autre disjoncteur de générateur (7) entre l'autre générateur et le transformateur de fréquence (5) à travers lequel l'autre générateur (1) est relié au transformateur de fréquence, et des enroulements (1A) de l'autre générateur à aimant permanent sont reliés à un autre point étoile (9), et lequel agencement comprend un autre disjoncteur de point étoile (10) entre les enroulements de l'autre générateur à aimant permanent et l'autre point étoile, l'agencement comprenant en outre une autre première mesure de courant (15) agencée pour mesurer des courants entre l'autre générateur (1) et le transformateur de fréquence (5), et une autre seconde mesure de courant (14) agencée pour mesurer des courants entre les enroulements (1A) de l'autre générateur à aimant permanent (1) et l'autre point étoile 9).

10. Agencement de générateur à arbre pour un navire selon la revendication 9, dans lequel le relais de protection (11) est relié à l'autre première (15) et à l'autre seconde (14) mesure de courant et à l'autre disjoncteur de point étoile (10) et à l'autre disjoncteur de générateur (7), lequel relais de protection est agencé pour ouvrir l'autre disjoncteur de point étoile si un court-circuit à 2 ou 3 phases entre les phases de l'autre générateur est détecté en réponse à l'autre première ou à l'autre seconde mesure, et ouvrir l'autre disjoncteur de générateur si un double défaut à la terre est détecté en réponse à ladite autre première et à ladite autre seconde mesure.

11. Agencement de générateur à arbre pour un navire selon l'une quelconque des revendications 1 à 8, dans lequel l'agencement comprend en outre un autre relais de protection (11) relié à l'autre première (15) et à l'autre seconde (14) mesure de courant et à l'autre disjoncteur de point étoile (10) et à l'autre disjoncteur de générateur (7), lequel relais de protection est agencé pour ouvrir l'autre disjoncteur de point étoile si un court-circuit à 2 ou 3 phases entre les phases de l'autre générateur est détecté en réponse à l'autre première ou à l'autre seconde mesure, et ouvrir l'autre disjoncteur de générateur si un double défaut à la terre est détecté en réponse à ladite autre première et à ladite autre seconde mesure.

12. Agencement de générateur à arbre pour un navire selon l'une quelconque des revendications 1 à 11, dans lequel l'agencement comprend un disjoncteur de réseau (8) entre le transformateur de fréquence (5) et le réseau (6) du navire.
